Europäisches Patentamt

European Patent Office

Office européen des brevets

(19)

(11) Numéro de publication : **0 376 810 B1**

(12) **FASCICULE DE BREVET EUROPEEN**

(45) Date de publication du fascicule du brevet :
**12.08.92 Bulletin 92/33**

(51) Int. CI.$^5$ : **H05K 7/20**

(21) Numéro de dépôt : **89403593.0**

(22) Date de dépôt : **21.12.89**

(54) **Armoire de machine de traitement de signaux refroidie par ventilation.**

(30) Priorité : **27.12.88 FR 8817207**

(43) Date de publication de la demande :
**04.07.90 Bulletin 90/27**

(45) Mention de la délivrance du brevet :
**12.08.92 Bulletin 92/33**

(84) Etats contractants désignés :
**DE ES FR GB IT NL SE**

(56) Documents cités :
**EP-A- 0 162 960**
**DE-U- 8 621 144**
**DE-U- 8 714 894**
**IEEE TRANSACTIONS ON NUCLEAR**
**SCIENCE. vol. 33, no. 1, février 1986, New**
**York,US,pages 838 - 840; HALDEMAN et al.:**
**"Fastbusrack alarms and limits."**

(73) Titulaire : **BULL S.A.**
**121, Avenue de Malakoff**
**F-75116 Paris (FR)**

(72) Inventeur : **Bruges, Jean-Claude**
**25, Avenue de la Grande Armée**
**F-75016 Paris (FR)**

(74) Mandataire : **Denis, Hervé et al**
**BULL S.A. Industrial Property Department**
**P.C.: HQ 8M006 P.B. 193.16 121 avenue de**
**Malakoff**
**F-75764 Paris Cédex 16 (FR)**

EP 0 376 810 B1

**Description**

L'invention se rapporte à une armoire de machine de traitement de signaux refroidie par ventilation, comprenant un filtre à air associé amoviblement à un dispositif de détection de présence de filtre. L'invention concerne plus particulièrement les machines à forte dissipation thermique, telles que les machines des grands et moyens systèmes d'informatique.

Un filtre à air est ordinairement fait d'un treillis porté par un cadre que l'on engage par coulissement sur des glissières au bas de l'armoire parallèlement au sol; cf par exemple DE-U-8 621 144. Son rôle est d'arrêter les poussières et les objets qui pourraient être aspirés par les ventilateurs et nuire au fonctionnement normal de la machine. Notamment, l'accumulation de poussières sur les composants et leurs éléments d'interconnexion altère la qualité désirée du refroidissement et de l'isolation électrique. La présence du filtre est capitale et est donc en permanence contrôlée par un détecteur, couramment un interrupteur actionné par le bord d'engagement du filtre lorsque ce dernier est correctement mis en place dans la machine.

Le filtre à air pose d'abord un problème de maintenance. Normalement, il devrait être changé lorsqu'il abaisse à une valeur critique de seuil le signal de détection de la dépression créée par les ventilateurs et nécessaire au bon fonctionnement de la machine. Mais étant donné que le retrait du filtre actionne le détecteur de présence pour arrêter la machine, on profite généralement d'un arrêt obligatoire ou intentionnel de la machine pour changer le filtre. L'arrêt et la remise en fonctionnement normal d'un calculateur sont en effet des opérations beaucoup trop gênantes et coûteuses pour être déclenchées simplement pour changer un filtre. En pratique, on change donc le filtre plus tôt ou plus tard qu'il ne devrait. Pendant l'arrêt de la machine, une partie des poussières mises en vibration lors du retrait du filtre est attirée par effet électrostatique vers les composants et leur support et peut nuire à la longue au refroidissement ou à l'isolation électrique. Une autre partie non négligeable des poussières tombe sur le sol. Ces poussières sont à nouveau aspirées lors de la remise en fonctionnement de la machine et encrassent déjà en partie le nouveau filtre. En outre, la tendance actuelle de faire la maintenance sans arrêt de la machine aggrave considérablement le problème du remplacement du filtre.

Certaines conditions d'utilisation de la machine peuvent créer d'autres problèmes. C'est le cas par exemple de législations nationales qui imposent qu'une plaque métallique soit en permanence placée sous les composants facilement inflammables ou susceptibles de dégager des fumées nocives en cas d'incendie. Le remède apporté consiste actuellement à disposer sous la machine une plaque métallique massive, encombrante, inesthétique et difficile à mettre en place. Il faut placer la machine à l'endroit désiré, et la monter sur des vérins pour la positionner par rapport au sol et à la plaque.

L'invention apporte une solution simple, efficace et peu coûteuse à tous ces problèmes.

Selon l'invention, une armoire de machine de traitement de signaux, comprenant un filtre à air associé amoviblement à un dispositif de détection ayant un état représentatif de la présence du filtre, est caractérisée en ce qu'elle comporte des moyens pour superposer au filtre un second filtre identique et des moyens pour maintenir en ledit état le dispositif de détection en présence du second filtre indépendamment de la présence du premier filtre.

Les caractéristiques et avantages de l'invention ressortiront de la description qui suit, donnée à titre d'exemple et faite en référence aux dessins annexés.

Dans les dessins :
– la figure 1 illustre la partie basse d'une armoire conforme à l'invention d'une machine de traitement de signaux refroidie par ventilation, vue en coupe schématique verticale faite selon la ligne I-I de la figure 2 qui correspond au plan médian perpendiculaire aux faces avant et arrière de l'armoire ;
– la figure 2 est une vue en coupe schématique verticale selon la ligne II-II de la figure 1, représentative du plan médian parallèle aux faces avant et arrière de la partie basse de l'armoire représentée sur la figure 1 ;
– la figure 3 est une vue en plan du filtre à air représenté sur les figures 1 et 2 ;
– les figures 4A-4C sont des vues sensiblement similaires à celle de la figure 1, illustrant diverses étapes du procédé de remplacement du filtre à air dans l'armoire conforme à l'invention représentée sur les figures 1 et 2 ; et
– la figure 5A illustre une variante de réalisation de la partie basse d'une armoire conforme à l'invention vue en coupe schématique similaire à celle de la figure 1, et les figures 5B-5D illustrent diverses étapes du procédé de remplacement du filtre à air dans l'armoire représentée sur la figure 5A.

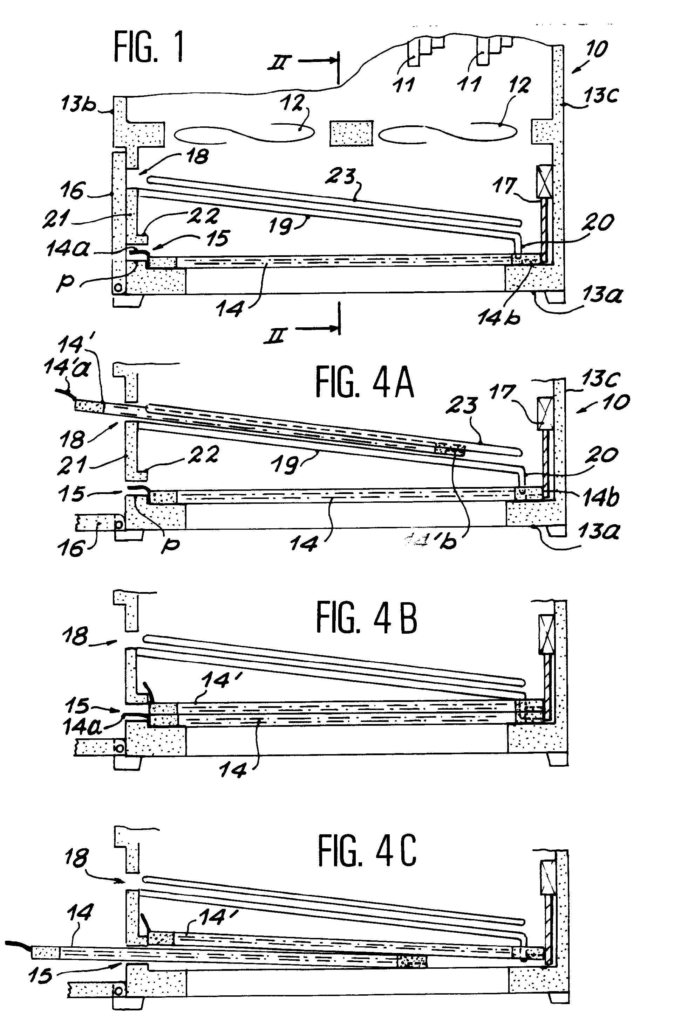

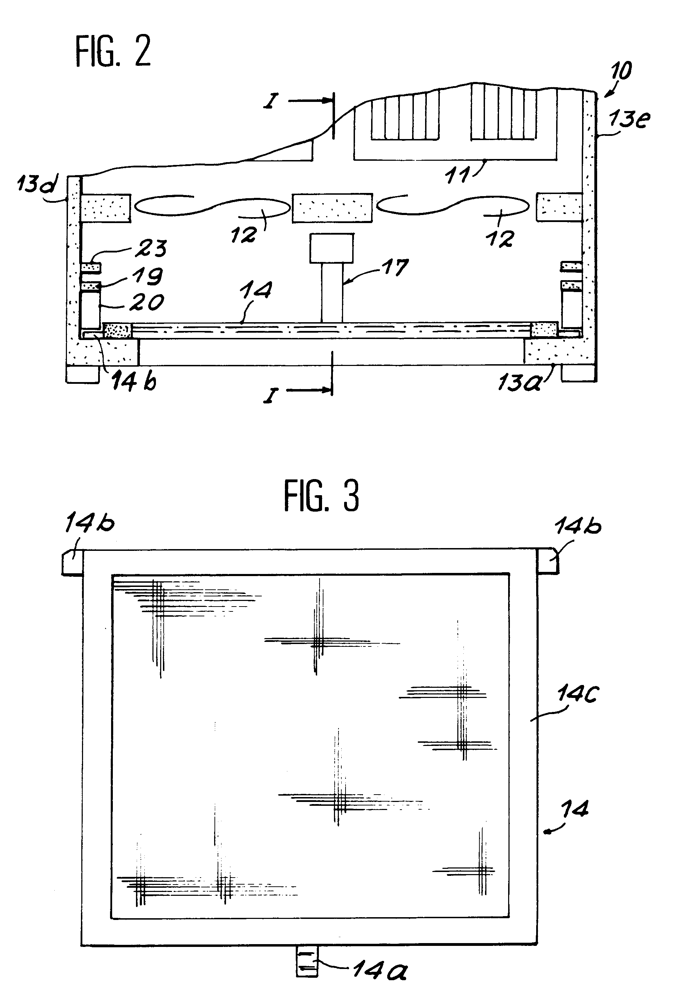

Les figures 1 et 2 illustrent schématiquement la partie basse d'une armoire 10 conforme à l'invention d'une machine de traitement de signaux. L'invention a été appliquée à une armoire pour un grand système d'informatique. Dans les dessins, des éléments de l'armoire 10 ont été diversement grossis pour les mettre clairement en relief. Dans l'armoire 10, les composants 11 sont essentiellement des cartes d'interconnexion de circuits intégrés associés à des radiateurs pour leur refroidissement. Des ventilateurs 12 sont disposés dans la partie basse de l'armoire 10 pour ventiler les radiateurs avec l'air aspiré à travers la paroi 13a du fond de l'armoire 10. La paroi de fond 13a est un cadre présentant ordinairement une ou deux fenêtres sensiblement rectangulaire pour l'entrée d'air de ventilation. Le cadre 13a illustré présente une seule fenêtre. Chaque fenêtre est fermée par un filtre à air 14 parallèle au sol et porté par le cadre 13a du fond de l'armoire 10. Le filtre 14 utilisé dans l'armoire 10 illustrée est vu en coupe sur les figures 1 et 2 et en plan sur la figure 3. C'est ordinairement un cadre rigide métallique sur lequel est tendu le treillis de filtrage de l'air. Un bord du filtre 14 porte une languette souple 14a. Une fente 15 dans la paroi avant 13b de l'armoire 10 permet l'insertion ou le retrait du filtre 14. Elle a sensiblement les dimensions de la largeur et de l'épaisseur du filtre 14. Dans l'exemple illustré, le bord inférieur de la fente 15 coincide avec le bord avant de la face supérieure du cadre de la paroi de fond 13a de l'armoire 10. De plus, le bord avant du cadre 13a forme un palier p réhaussé par rapport à la surface suprême de l'ensemble du cadre 13a. Un volet rabattable 16 assure la fermeture de la fente 15 en fonctionnement normal de la machine. Sur la paroi arrière 13c de l'armoire 10 est monté un dispositif de détection 17 de présence du filtre 14. Le dispositif de détection illustré est un interrupteur à palette actionné perpendiculairement à la face arrière 13c. Cette structure est classique dans les armoires actuelles.

Dans une armoire classique telle que décrite précédemment, la mise en place d'un filtre 14 est le suivant. Le filtre 14 est introduit par la fente 15, puis il vient en contact avec la palette de l'interrupteur 17 pour l'amener dans une position finale indiquant la présence du filtre et son positionnement correct. Dans cette position, le filtre 14 est logé dans le renfoncement du cadre de la paroi de fond 13a et s'appuie contre le palier p et, à l'arrière, contre la palette d'interrupteur 17. L'interrupteur 17 est ainsi assuré du positionnement correct du filtre 14 dans l'armoire 10 et autorise le fonctionnement normal de la machine. Pour le retrait du filtre, on fait basculer le volet 16 et on tire sur la languette 14a du filtre 14. La palette de l'interrupteur 17 se relâche jusqu'à une position représentative d'un positionnement incorrect du filtre. L'interrupteur 17 commande alors l'arrêt du fonctionnement de la machine.

L'invention présente une structure d'armoire permettant le remplacement du filtre 14 sans arrêter le fonctionnement de la machine. Dans l'exemple illustré dans les figures 1 et 2, la paroi avant 13b de l'armoire 10 présente une fente supérieure 18 parallèle et identique à la fente inférieure 15. Les parois latérales 13d et 13e de l'armoire 10 portent chacune une glissière 19 s'étendant de la fente supérieure 18 jusqu'à une position proche de la palette de l'interrupteur 17. Les glissières 19 sont adaptées à deux pattes 14b du filtre 14 portées respectivement par les deux bords latéraux du cadre du filtre 14. Dans l'exemple illustré, les deux pattes 14b sont situées à l'extrémité opposée au bord du filtre 14 portant la languette 14a et sont coplanaires avec la face inférieure du filtre 14 et de hauteur sensiblement inférieure à la hauteur du cadre du filtre. Vers l'arrière de l'armoire 10, les glissières 19 se prolongent pour former des nervures 20 s'étendant dans un plan sensiblement parallèle à la palette d'interrupteur 17 quand elle est en position représentative de la présence correcte d'un filtre 14 dans l'armoire 10. La distance entre le plan des nervures et la palette d'interrupteur 17 correspond à la distance de cette palette avec le bord avant (vers la languette 14a) des pattes 14b d'un filtre 14 lorsqu'il est en position finale d'engagement dans l'armoire 10. Les nervures s'étendent vers le bas de l'armoire jusqu'à une position correspondant sensiblement à la position haute des pattes 14b du filtre 14 lorsqu'il repose sur la paroi de fond 13a de l'armoire 10. Les fentes 15 et 18 sont séparées par une bande 21 de la paroi frontale 13b de l'armoire 10. Dans l'exemple illustré, la partie basse de la bande 21 se prolonge par un rebord 22 parallèle à la paroi de fond 13a de l'armoire 10 et de longueur approximativement égale à la longueur du palier p. Dans l'exemple illustré, le rebord 22 se prolonge légèrement vers la fente supérieure 18. Le volet 16 est étendu pour fermer les ouvertures 15 et 18 pendant le fonctionnement normal de la machine. Accessoirement, l'armoire 10 porte sur ses parois latérales 13d, 13e des saillies 23 disposées au-dessus des glissières 19 et, dans l'exemple illustré, parallèlement aux glissières 19.

On suppose maintenant que le filtre 14 en place sur la paroi de fond 13a de l'armoire 10 est sale et doit être remplacé. On ouvre alors le volet 16 pour avoir accès aux fentes 15 et 18. Par la fente supérieure 18, on introduit le filtre propre 14' de façon que ses pattes 14'b coulissent sur les glissières 19 (figure 4A). Les saillies 23 servent de limites supérieures à la position haute admissible du filtre propre 14', pour éviter par exemple d'approcher les pales des ventilateurs 12. Le filtre 14' descend jusqu'à venir en contact avec la palette d'interrupteur 17. Dans cette position, les bords avant des pattes 14'b sont guidés par les nervures 20. La languette 14'a du nouveau filtre est lâchée. Le nouveau filtre 14' descend alors par gravitation, en étant guidé par les nervures 20 pour rester en contact avec la palette d'interrupteur 17. Le nouveau filtre 14' vient ainsi se placer contre le filtre sale 14 (figure 4B). Par la fente inférieure 15, on tire sur la languette 14a pour extraire le filtre sale 14. Au cours de l'extraction (figure 4C), le nouveau filtre 14' prend progressivement la place du filtre 14. Grâce à la butée 22, le nouveau filtre demeure en contact avec la palette d'interrupteur 17 jusqu'à sa mise en place finale. Le remplacement du filtre à air 14 s'est donc fait sans interruption du fonctionnement de la machine contenue dans l'armoire 10. Si le treillis de filtrage des filtres 14 et 14' est métallique, l'invention offre aussi l'avantage d'assurer la présence continuelle d'une paroi métallique de fond de l'armoire 10 en vue de convenir aux normes de sécurité prescrites.

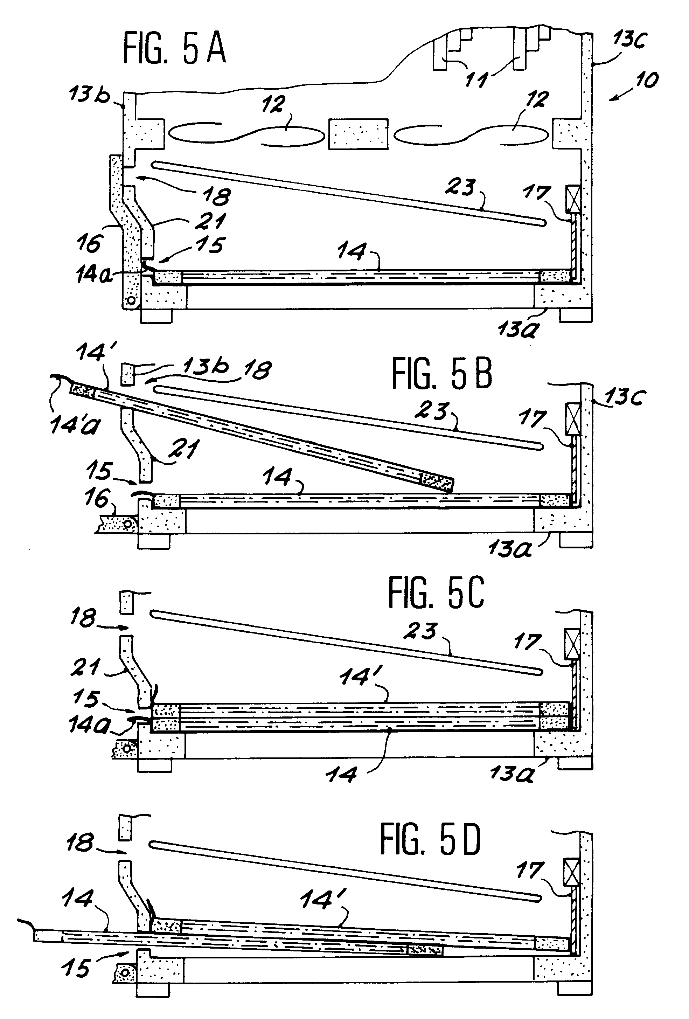

La figure 5A illustre de façon similaire à la figure 1 une variante de réalisation de la partie basse d'une armoire 10 conforme à l'invention d'une machine de traitement de signaux. Les éléments communs des armoires 10 représentées sur les figures 1 et 5A portent les mêmes chiffres de référence. Les armoires 10 représentées sur les figures 1 et 2 ont notamment en commun, selon l'invention, la fente supérieure 18, le volet 16, et les saillies 23. Selon la variante, les filtres à air ne portent pas de pattes 14b et l'armoire 10 ne porte pas de glissières 19 et de nervures 20, et la fente inférieure 15 ne dispose pas du palier p et du rebord associé 22. Dans la figure 5A, la fente 15 débouche directement sur la face supérieure de la paroi de fond 13a de l'armoire 10, sans l'intermédiaire d'un palier p. La paroi frontale 13b porte la fente supérieure 18, et la bande 21 s'incurve vers la paroi arrière pour aboutir à la fente 15. La fente 15 est donc plus proche de la paroi arrière 13b que la fente supérieure 18.

Le remplacement du filtre 14 de l'armoire 10 représentée sur la figure 5A va maintenant être décrit en référence aux figures 5B-5D illustrant diverses étapes analogues à celles des figures 4A-4C, respectivement. Comme indiqué à la figure 5B, le nouveau filtre 14' est introduit par l'ouverture supérieure 18 et glisse sur la surface supérieure 14c des bords latéraux du filtre à remplacer 14. En fin d'introduction, on lâche la languette 14'a de façon que le nouveau filtre 14' vienne se superposer au filtre sale 14 (figure 5C). Dans sa descente, le nouveau filtre 14' est guidé par la bande 21 de la paroi 13a comprise entre les ouvertures 15 et 18. En enlevant le filtre sale 14 par la fente 15, le nouveau filtre se met progressivement en place (figure 5D). Grâce à la butée formée par le bas de la bande 21, le nouveau filtre 14' demeure en contact avec la palette d'interrupteur 17. Finalement, le nouveau filtre 14' prend sa position finale, en remplacement du filtre 14 illustré dans la figure 5A. On rabat ensuite le volet 16 pour fermer les fentes 15 et 18. Les figures 5A-5D font donc ressortir que, d'une part, la face supérieure 14c du filtre 14 sert de glissière pour le filtre 14' et remplace les glissières 19 de l'armoire 10 des figures 1 et 2 et, d'autre part, la forme de la bande 21 a la même fonction que les nervures 20 et le rebord 22 de l'armoire 10 des figures 1 et 2. Par sa simplicité, l'armoire 10 représentée sur la figure 5A constitue le mode de réalisation préféré de l'invention.

L'invention comporte évidemment d'autres variantes de réalisation. Par exemple, l'interrupteur 17 peut être conçu pour indiquer seulement la présence du filtre 14, au lieu de la position correcte du filtre comme dans les exemples illustrés. L'interrupteur 17 pourrait être d'un type sans palette. Dans ce cas, au terme "position de la palette" dans les exemples illustrès correspond plus généralement le terme "état", représentatif de la présence du filtre et, éventuellement, de la position correcte du filtre. En outre, il est clair que la bande 21 dans l'armoire 10 de la figure 5A pourrait aussi être droite, comme la bande 21 de l'armoire 10 des figures 1 et 2. La fente 18 pourrait aussi être placée en dessous de la fente 15.

## Revendications

1. Armoire (10) de machine de traitement de signaux, comprenant un filtre à air (14) associé amoviblement à un dispositif de détection (17) ayant un état représentatif de la présence du filtre, l'armoire comportant en outre des moyens (18, 19) pour superposer au filtre un second filtre identique (14') et des moyens (20, 22) pour maintenir en ledit état le dispositif de détection en présence du second filtre indépendamment de la présence du premier filtre.

2. Armoire selon la revendication 1, du type comprenant une première fente (15) dans une paroi (13b) de l'armoire (10) pour le passage du premier filtre, caractérisée en ce que les moyens de superposition dudit filtre comprennent une seconde fente (18) pour le passage du second filtre.

3. Armoire selon la revendication 1 ou 2, caractérisée en ce que la seconde fente (18) est placée au-dessus de la première fente (15).

4. Armoire selon la revendication 2 ou 3, caractérisée en ce que la seconde fente (18) est associée à des glissières (19) pour l'introduction du second filtre (14').

5. Armoire selon la revendication 2 ou 3, caractérisée en ce que la face supérieure des bords latéraux du premier filtre servent de glissières pour la mise en place du second filtre (figures 5A et 5B).

6. Armoire selon l'une des revendications 1 à 5, caractérisée en ce que les moyens de maintien précités comprennent des nervures (20) coopérant avec des pattes (14'b) du second filtre (14).

7. Armoire selon la revendication 6, caractérisée en ce que les moyens de maintien comportent un rebord supérieur (22) de la première fente (15), qui se superpose avec sensiblement les mêmes dimensions au palier (p) séparant la première fente au premier filtre.

8. Armoire selon l'une des revendications 1 à 5, caractérisée en ce que les moyens de maintien comprennent une mise en forme de la bande (21) séparant les première et seconde fentes (15, 18) telle que le second filtre (14') vienne se superposer au premier filtre (14) en étant calé entre ladite bande et le dispositif de détection (17) et le restant pendant le retrait du premier filtre par la première fente (15).

9. Armoire selon l'une des revendications 1 à 8, caractérisée en ce que les filtres sont métalliques.

10. Armoire selon l'une des revendications 1 à 9, caractérisée en ce que le dispositif de détection (17) est un interrupteur à palette.

dadurch gekennzeichnet, daß die Erkennungseinrichtung (17) ein Anker-Unterbrecher ist.

**Patentansprüche**

1. Schrank (10) für eine Signalverarbeitungsmaschine, mit einem Luftfilter (14), dem eine Erkennungseinrichtung (17) ablösbar zugeordnet ist, die einen das Vorhandensein des Filters darstellenden Zustand besitzt, wobei der Schrank außerdem versehen ist mit Mitteln (18, 19), um über dem Filter ein zweites identisches Filter (14') anzuordnen, und Mitteln (20, 22), um die Erkennungseinrichtung bei Vorhandensein des zweiten Filters unabhängig vom Vorhandensein des ersten Filters im genannten Zustand zu halten.

2. Schrank gemäß Anspruch 1 von einer Bauart, die in einer Wand (13b) des Schranks (10) einen ersten Schlitz zum Durchschieben des ersten Filters aufweist, dadurch gekennzeichnet, daß die Mittel zum Übereinanderanordnen des Filters einen zweiten Schlitz (18) zum Durchschieben des zweiten Filters aufweisen.

3. Schrank gemäß Anspruch 1 oder 2, dadurch gekennzeichnet, daß der zweite Schlitz (18) oberhalb des ersten Schlitzes (15) angeordnet ist.

4. Schrank gemäß Anspruch 2 oder 3, dadurch gekennzeichnet, daß der zweite Schlitz (18) mit Gleitschienen (19) für die Einführung des zweiten Filters (14') verbunden ist.

5. Schrank gemäß Anspruch 2 oder 3, dadurch gekennzeichnet, daß die Oberseiten der Seitenkanten des ersten Filters als Gleitschienen zum Einsetzen des zweiten Filters dienen (Fig. 5A und 5B).

6. Schrank gemäß einem der Ansprüche 1 bis 5, dadurch gekennzeichnet, daß die obenerwähnten Haltemittel Rillen (20) aufweisen, die mit Ansätzen (14'b) des zweiten Filters (14) zusammenwirken.

7. Schrank gemäß Anspruch 6, dadurch gekennzeichnet, daß die Haltemittel einen oberen umgebogenen Rand (22) des ersten Schlitzes (15) aufweisen, der sich im wesentlichen mit den gleichen Abmessungen über der den ersten Schlitz vom ersten Filter trennenden Stufe (p) befindet.

8. Schrank gemäß einem der Ansprüche 1 bis 5, dadurch gekennzeichnet, daß die Haltemittel eine solche Gestaltung des den ersten und den zweiten Schlitz (15, 18) trennenden Bandes (21) umfassen, daß der zweite Filter (14') über dem ersten Filter (14) zu liegen kommt und dabei zwischen dem Band und der Erkennungseinrichtung (17) verkeilt wird, und während des Herausziehens des ersten Filters durch den ersten Schlitz (15) festgehalten wird.

9. Schrank gemäß einem der Ansprüche 1 bis 8, dadurch gekennzeichnet, daß die Filter aus Metall sind.

10. Schrank gemäß einem der Ansprüche 1 bis 9,

**Claims**

1. A cabinet (10) for a computing machine, including an air filter (14) detachably associated with a detection device (17) having a state representative of the presence of the filter, the cabinet further including means (18,19) to superpose on the filter a second identical filter (14') and means (20,22) to maintain the detection device in said state in the presence of the second filter independently of the presence of the first filter.

2. A cabinet according to Claim 1, of the type comprising a first slot (15) in a wall (13b) of the cabinet (10) for the passage of the first filter, characterised in that the means for superpositioning said second filter comprises a second slot (18) for the passage of the second filter.

3. A cabinet according to Claim 1 or 2, characterised in that the second slot (18) is placed above the first slot (15).

4. A cabinet according to Claim 2 or 3, characterised in that the second slot (18) is associated with guides (19) for the introduction of the second filter (14').

5. A cabinet according to Claim 2 or 3, characterised in that the upper face of lateral edges of the first filter serve as guides for placement of the second filter (Figures 5A and 5B).

6. A cabinet according to one of claims 1 to 5, characterised in that the aforementioned maintenance means comprise ribs (20) cooperating with lugs (14'b) of the second filter (14).

7. A cabinet according to Claim 6, characterised in that the maintenance means comprise an upper flange (22) of the first slot (15), which aligns with and has substantially the same dimensions as a bearing (p) separating the first slot from the first filter.

8. A cabinet according to one of claims 1 to 5, characterised in that the maintenance means comprise a member in the form of the band (21) separating the first and second slots (15,18) such that the second filter (14') will superpose itself on the first filter (14) while being wedged between said band and the detection device (17) and remaining in a superposed position during removal of the first filter through the first slot (15).

9. A cabinet according to one of claims 1 to 8, characterised in that the filters are metallic.

10. A cabinet according to one of claims 1 to 9, characterised in that the detection device (17) is a switch with a paddle.

FIG. 1

FIG. 4 A

FIG. 4 B

FIG. 4 C

FIG. 2

FIG. 3

FIG. 5 A

FIG. 5 B

FIG. 5C

FIG. 5 D